(19) Europäisches Patentamt
European Patent Office
Office européen des brevets

(11) **EP 1 782 528 B1**

(12) **EUROPÄISCHE PATENTSCHRIFT**

(45) Veröffentlichungstag und Bekanntmachung des Hinweises auf die Patenterteilung:
**26.08.2015   Patentblatt 2015/35**

(21) Anmeldenummer: **05777842.5**

(22) Anmeldetag: **28.07.2005**

(51) Int Cl.:
*H02P 1/28* (2006.01)        *H02M 5/257* (2006.01)

(86) Internationale Anmeldenummer:
**PCT/EP2005/053698**

(87) Internationale Veröffentlichungsnummer:
**WO 2006/015952 (16.02.2006 Gazette 2006/07)**

(54) **VERFAHREN ZUM BETREIBEN EINES ZWEIPHASIGEN DREHSTROMSTELLERS**

METHOD FOR OPERATING A TWO-PHASE ROTARY CURRENT CONTROLLER

PROCEDE PERMETTANT DE FAIRE FONCTIONNER UN REGULATEUR DE COURANT TRIPHASE/BIPHASE

(84) Benannte Vertragsstaaten:
**AT BE BG CH CY CZ DE DK EE ES FI FR GB GR HU IE IS IT LI LT LU LV MC NL PL PT RO SE SI SK TR**

(30) Priorität: **05.08.2004   DE 102004038111**

(43) Veröffentlichungstag der Anmeldung:
**09.05.2007   Patentblatt 2007/19**

(73) Patentinhaber: **Siemens Aktiengesellschaft 80333 München (DE)**

(72) Erfinder:
• **GRIEPENTROG, Gerd**
  **91468 Gutenstetten (DE)**
• **FRITSCH, Andreas**
  **92245 Kümmersbruck (DE)**
• **RUNGGALDIER, Diethard**
  **96135 Stegaurach (DE)**

(56) Entgegenhaltungen:
WO-A-01/48903        GB-A- 1 227 963
US-A- 4 101 819      US-A- 5 682 091

**Beschreibung**

Die Erfindung betrifft ein Verfahren zum Betreiben eines zweiphasigen Drehstromstellers. Darüber hinaus betrifft die Erfindung einen zweiphasiger Drehstromsteller. Relevanter Stand der Technik: WO 01/48903 A (MOELLER GMBH; MAGYAR, PETER), US 5 682 091 A (WILLIAMSON ET AL), GB 1 227 963 A (GENERAL ELECTRIC COMPANY), US 4 101 819 A (MAEDA ET AL).

J Drehstromsteller dosieren nach dem Prinzip des Phasenanschnitts die einer elektrischen Last, insbesondere einer Asynchronmaschine, zugeführte elektrische Leistung. Durch diese Dosierung der zugeführten Leistung kann bei Asynchronmaschinen eine Reduzierung von Anlaufströmen und Anlaufmomenten und damit ein so genannter Sanftanlauf realisiert werden. Als Maß der Dosierung wird die so genannte Zündverzögerung $\alpha$, die auch als Delay bezeichnet wird, herangezogen. Die am Ausgang des Drehstromstellers angeschlossene Last wird von Stromhalbwellen wechselnder Polarität durchflossen, wobei zwischen jeweils zwei aufeinander folgenden Stromhalbwellen ein durch den Phasenanschnitt bestimmter stromloser Zeitabschnitt liegt.

Normalerweise werden Drehstromsteller in ihrem Leistungsteil mit drei Sätzen antiparalleler Thyristoren ausgerüstet. Da die Kosten für die Thyristoren mit zunehmender Nennleistung der Drehstromsteller jedoch der für das Gesamtgerät kostenbestimmende Faktor sind, werden auch Drehstromsteller mit nur zwei Sätzen antiparalleler Thyristoren eingesetzt. Bei diesen so genannten zweiphasigen Drehstromstellern ist der verbleibende Außenleiter als nicht schaltbarer Leiter ausgeführt. Ein Nebeneffekt dieses im Aufbau reduzierten, zweiphasigen Drehstromstellers besteht darin, dass die Effektivwerte der Ströme in den beiden gesteuerten Außenleitern trotz gleicher Phasenanschnittwinkel unterschiedlich sind. Dieser Effekt ist auf die magnetische Wechselwirkung der drei Außenleiterströme in der angesteuerten Asynchronmaschine zurückzuführen und von der Drehrichtung des Netzes bzw. der Asynchronmaschine abhängig. Durch die ungleichmäßig hohen Ströme müssen die Leistungshalbleiter (Thyristoren) sowie deren Kühlkörper auf höhere Werte als erforderlich ausgelegt werden, da eine Beherrschung des jeweils höheren Stromes notwendig ist. Welcher der beiden Ströme in den gesteuerten Außenleitern höher ist, hängt von der Drehrichtung des angeschlossenen Netzes ab und kann demnach variieren. Diesem Effekt wurde bislang dadurch Rechnung getragen, dass die Leistungshalbleiter so ausgelegt sind, dass jeder der beiden Ventilsätze in den beiden gesteuerten Außenleitern den höheren Strom tragen kann.

Eine Aufgabe der vorliegenden Erfindung ist es, den Betrieb eines zweiphasigen Drehstromstellers zu optimieren. Diese Aufgabe wird durch ein Verfahren nach Anspruch 1 bzw. einen Drehstromsteller nach Anspruch 6 gelöst.

Ein Grundgedanke der Erfindung besteht darin, Beträge eines in den beiden steuerbaren Phasen eines zweiphasigen Drehstromstellers veränderbaren Parameters in diesen Phasen anzugleichen.

Insbesondere wird das bisherige Prinzip der phasensymmetrischen Ansteuerung mit einer einheitlichen Zündverzögerung in den beiden gesteuerten Außenleitern aufgegeben und für jeden der beiden gesteuerten Außenleiter eine eigene Zündverzögerung vorgegeben. Anders ausgedrückt erfolgt eine phasen-unsymmetrische Ansteuerung derart, dass die Effektivwerte der Ströme in den beiden gesteuerten Phasen einander angeglichen werden. Das Angleichen erfolgt dabei insbesondere beim Anlauf der Asynchronmaschine, um die dort auftretenden Parameterunterschiede zu vermeiden. Prinzipiell kann das Angleichen auch während des Normalbetriebes erfolgen.

Durch die mit Hilfe des erfindungsgemäßen "Phase-Balancer-Prinzips" einander angenäherten Parameterwerte, insbesondere Ströme, in den beiden gesteuerten Außenleitern brauchen die verwendeten Ventilsätze (Leistungshalbleiter) nicht mehr auf den zu erwartenden Maximalwert ausgelegt werden. Für einen sicheren Betrieb ist eine Auslegung auf den geringeren Mittelwert aus beiden Außenleitern ausreichend. Hierdurch ist eine deutliche Kosteneinsparung möglich. Ein weiterer Vorteil des erfindungsgemäßen Verfahrens liegt in der gleichmäßigeren Netzbelastung. Zudem erfolgt eine automatische Parameterangleichung auch bei netzseitigen Spannungs-Unsymmetrien.

Mit der vorliegenden Erfindung kann mit zweiphasigen Drehstromstellern annähernd die gleiche Funktionalität hinsichtlich der Reduzierung von Anlaufströmen und Drehmomenten während des Anlaufs erzielt werden, wie dies mit dreiphasigen Drehstromstellern möglich ist.

Weitere vorteilhafte Ausführungsformen der Erfindung sind in den Unteransprüchen angegeben und werden nachfolgend mit Hilfe von Zeichnungen anhand eines Ausführungsbeispiels näher erläutert. Hierbei zeigen:

FIG 1   Phasenanschnitt, Drehzahl und Drehmoment bei einem Drehstromsteller nach dem Stand der Technik,

FIG 2   einen Verlauf der Effektivwerte der Ströme sowie die Stromdifferenz bei einem Drehstromsteller nach dem Stand der Technik,

FIG 3   Phasenanschnitt, Drehzahl und Drehmoment bei einem erfindungsgemäßen Drehstromsteller und

FIG 4   einen Verlauf der Effektivwerte der Ströme sowie die Stromdifferenz bei einem erfindungsgemäßen Drehstromsteller,

FIG 5   eine schematische Darstellung des erfindungsgemäßen Verfahrens.

Als Beispiel dient ein Drehstromsteller (Sanftstarter) zur Phasenanschnittsteuerung für eine Asynchronmaschine, wie er aus dem Stand der Technik bekannt ist. Lediglich die Ansteuerung des Drehstromstellers, die durch seine Steuereinheit realisiert wird, weist Modifikationen auf, die einen Betrieb des Drehstromstellers im Sinne der Erfindung ermöglichen. Da die Steuereinheit neben Messeinheiten, wie Stromwandlern und dergleichen, zumeist einen Mikroprozessor oder Mikrocontroller umfasst, sind diese Modifikationen vorzugsweise als ein in dem Mikroprozessor oder Mikrocontroller ablaufendes Computerprogramm oder in einer beliebigen anderen Form, beispielsweise als hartverdrahtete Schaltung, realisiert.

Für das folgende Ausführungsbeispiel wird exemplarisch davon ausgegangen, dass die beiden Außenleiter L1 und L3 gesteuert sind und der (konstruktiv in der Mitte liegende) Außenleiter L2 im Drehstromsteller, beispielsweise mittels einer Kupferbrücke, durchverbunden ist. Erfindungsgemäß sollen nun die Effektivwerte $I_{1rms}$ und $I_{3rms}$ angeglichen werden. Zunächst wird hierzu von der Steuereinheit des Drehstromstellers eine Regelabweichung $\Delta I$ berechnet gemäß

$$\Delta I_k = (I_{1rms(k)} - I_{3rms(k)}) / I_N \qquad \text{(Gleichung 1)}$$

Der Index k kennzeichnet Werte zum Abtastzeit t = k · $T_A$, wobei $T_A$ im 50 Hz-Netz die Netzperiode mit $T_A$ = 20 ms sein kann. Eine Neuberechnung erfolgt in diesem Fall einmal pro Netzperiode. Eine Abtastung kann aber auch alle zwei, drei oder vier Netzperioden usw. erfolgen. Die Regelabweichung nach Gleichung 1 ist dabei auf den Nennstrom IN des Drehstromstellers normiert, also dimensionslos.

Die "globale" Zündverzögerung $\alpha$, welche den Zeitraum zwischen dem Löschen des Stromes und der nächsten Zündung angibt, wird von der Steuerung des Drehstromstellers aufgrund der am Gerät eingestellten Parameter (Startspannung, Rampenzeit und dergleichen) in bekannter Weise vorgegeben. Um gleiche Effektivwerte in den beiden gesteuerten Außenleitern L1 und L3 zu erhalten, muss aus der "globalen" Zündverzögerung $\alpha$ für jeden gesteuerten Außenleiter, also für jeden Thyristor-Ventilsatz, eine eigene Zündverzögerung $\alpha 1$ und $\alpha 3$ abgeleitet werden. Diese, den Außenleitern L1 und L3 zugeordneten Zündverzögerungen werden während des Hochlaufens in der Steuereinheit aus der "globalen" Zündverzögerung $\alpha$ wie folgt berechnet:

$$\alpha_{1(k)} = \alpha_k - \Delta\alpha_k / 2$$

$$\alpha_{3(k)} = \alpha_k + \Delta\alpha_k / 2 \qquad \text{(Gleichung 2)}$$

Aus Gleichung 2 folgt, dass der Mittelwert der beiden Zündverzögerungen $\alpha 1$ und $\alpha 3$ der "globalen" Zündverzögerung $\alpha$ entspricht, ihre Differenz jedoch der Differenz-Zündverzögerung $\Delta\alpha$. Aufgrund der Stromdifferenz $\Delta I$ wird nun in einem weiteren Schritt die Differenz-Zündverzögerung $\Delta\alpha$ bestimmt. Dies geschieht auf Basis der nachfolgenden Gleichung:

$$\Delta\alpha_k = K_I \cdot T_A \sum_{\nu=0}^{k-1} \Delta I_\nu \qquad \text{(Gleichung 3)}$$

Dies bedeutet, dass die Differenz der Ströme in den beiden Außenleitern L1 und L3 vom Beginn des Startvorgangs an über die Zahl der vergangenen Netzperioden aufsummiert wird und aus dieser Summe gemäß Gleichung 3 die Differenz-Zündverzögerung $\Delta\alpha$ bestimmt wird (zeitdiskreter Integralregler). Die auch als Reglerverstärkung bezeichnete Konstante $K_I$ in Gleichung 3 nimmt vorteilhaft Werte in einem Bereich von etwa 0,03 bis 0,05 in einem 50 Hz-Netz an. Besonders vorteilhaft ist dabei ein $K_I$-Wert von 0,05. Zu große $K_I$-Werte würden hier zu einer Instabilität des Systems führen.

Es wird also nicht mehr, wie bisher, für jeden Außenleiter bzw. für jeden Ventilsatz der gleiche Phasenanschnitt vorgegeben. Vielmehr sind erfindungsgemäß unterschiedliche Phasenanschnitte, also unterschiedliche Zündverzögerungen, für die beiden gesteuerten Phasen vorgesehen. Dabei zeichnet sich das erfindungsgemäße Verfahren insbesondere dadurch aus, dass die Angleichung aufgrund aktueller Messdaten, sozusagen "online" erfolgt. Auf ungenaue Abschätzungen oder Vorabberechnungen muss nicht zurückgegriffen werden.

Die in Gleichung 3 angegebene Berechnungsmethode ist als Beispiel zu verstehen und kann selbstverständlich im Sinne der Erfindung modifiziert werden.

Die Wirksamkeit des erfindungsgemäßen Verfahrens wird aus den nachfolgend beschriebenen Figuren deutlich.

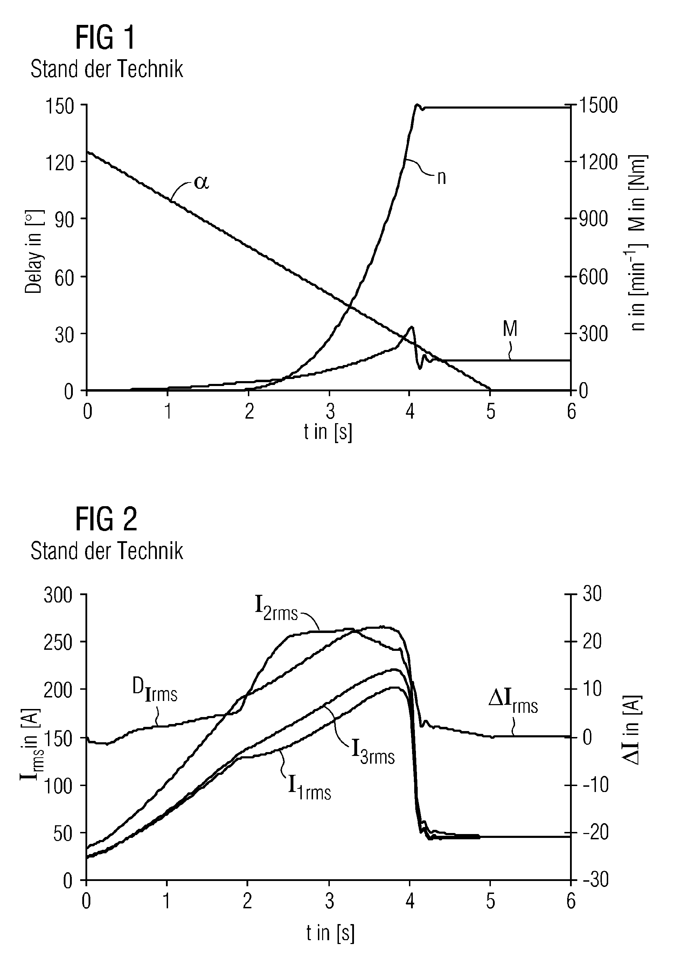

FIG 1 zeigt den Phasenanschnitt (Delay $\alpha$) in Grad, die Drehzahl n in min$^{-1}$ sowie das Drehmoment M in Nm über der Zeit t in Sekunden für einen herkömmlichen Drehstromsteller. In FIG 2 ist für den gleichen Zeitraum der Verlauf der Effektivwerte der Ströme I1, I2 und I3 sowie die Differenz der Ströme der gesteuerten Außenleiter am Beispiel einer 30 kW-Asynchronmaschine angegeben.

Etwa bei einer Zündverzögerung von $\alpha$ = 77° / 180° · 10 ms = 4,3 ms driften die Stromeffektivwerte in den beiden gesteuerten Außenleitern L1 und L3 zunehmend auseinander. $I_{3rms}$ übersteigt $I_{1rms}$ um ca. 22 Ampere, was etwa 40 % des Nennstromes (IN = 55 Ampere) ausmacht. Die Maximalwerte der effektiven Ströme betragen 202 Ampere (L1) bzw. 220 Ampere (L3).

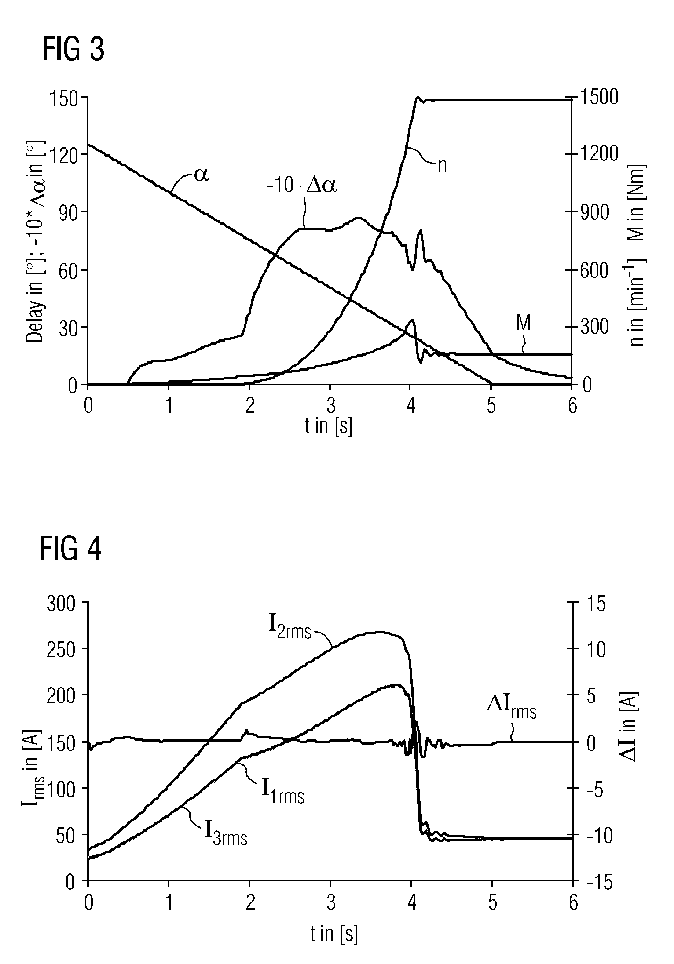

Betreibt man den für die FIG 1 und 2 genutzten Drehstromsteller mit dem erfindungsgemäßen Verfahren, so ergeben sich die in den FIG 3 und 4 angegebenen Kennlinien. Dabei ist aus Gründen der Übersichtlichkeit in FIG 3 für die Differenz-Zündverzögerung $\Delta\alpha$ der negative, zehnfache Wert dargestellt. Wie aus FIG 4 deutlich wird, sind die Effektwerte $I_{1rms}$, $I_{3rms}$ der Ströme in den beiden gesteuerten Außenleitern L1 und L3 einander weitgehend angenähert. Der Maximalwert liegt jetzt für beide Außenleiter bei ca. 210 Ampere, also etwa in der Mitte der Maximalwerte aus FIG 2.

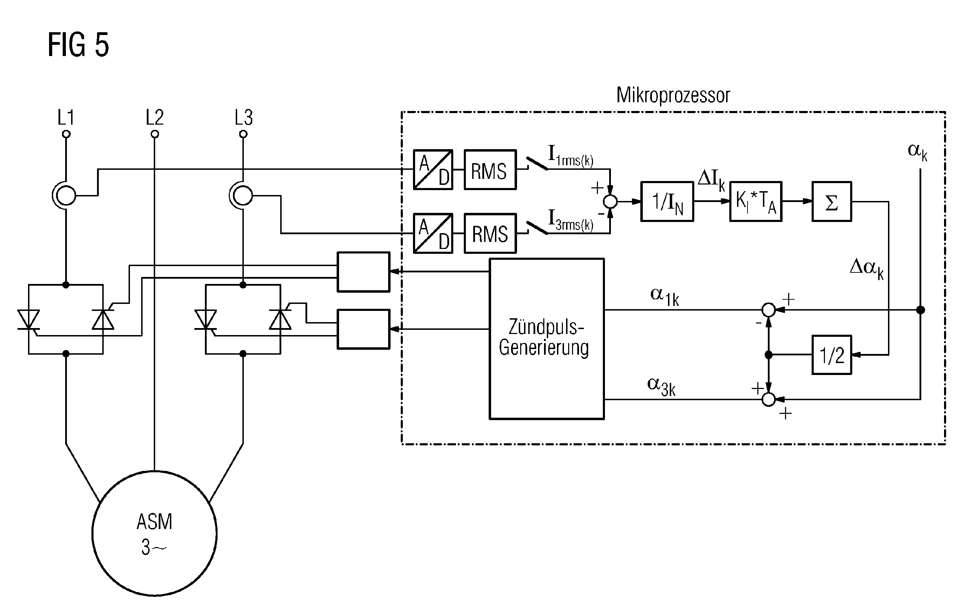

FIG 5 zeigt eine vereinfachte schematische Darstellung eines Drehstromstellers nach der Erfindung für eine Asynchronmaschine (ASM). Hierbei werden die Ströme in den beiden gesteuerten Außenleitern L1 und L3 mittels Stromwandler gemessen. Das Messsignal wird einem A/D-Wandler eines Mikroprozessors zugeführt. Aus den digitalisierten Werten wird mittels bekannter Verfahren der Effektivwert des Stromes für eine Netzperiode berechnet. Die beiden Effektivwerte werden voneinander abgezogen, auf den Nennstrom IN bezogen und mit dem Faktor $K_I \cdot T_A$ gewichtet. Der so gewichtete Wert wird einer Summenbildung unterzogen, woraus die Differenz-Zündverzögerung $\Delta\alpha$ bestimmt wird. Die Differenz-Zündverzögerung $\Delta\alpha$ wird jeweils von der globalen Zündverzögerung $\alpha$ abgezogen (L1) oder zu dieser addiert (L3). Hieraus entstehen die einzelnen Zündverzögerungen $\alpha1$ und $\alpha3$ für die beiden gesteuerten Außenleiter L1 und L3. Die beiden Zündverzögerungen $\alpha1$ und $\alpha3$ werden einer Schaltungslogik zugeführt, die hieraus die entsprechenden Zündimpulse für die Thyristoren generiert.

**Patentansprüche**

1. Verfahren zum Betreiben eines zweiphasigen Drehstromstellers in einem Dreiphasennetz, wobei eine Phasenanschnittsteuerung in zwei gesteuerten Phasen erfolgt, mit den Schritten:

   - Erfassen der Effektivwerte der in den beiden gesteuerten Phasen fließenden Ströme,
   - Aufsummieren der Differenz der in den beiden gesteuerten Phasen fließenden Ströme,
   - Bestimmen einer Zündverzögerung aus der aufsummierten Differenz der in den beiden gesteuerten Phasen fließenden Ströme, und
   - Erhöhen des Zündwinkels für die erste gesteuerte Phase und Erniedrigen des Zündwinkels für die zweite gesteuerte Phase um die bestimmte Zündverzögerung, derart, dass die Effektivwerte in den beiden gesteuerten Phasen angeglichen werden, wobei die Angleichung aufgrund aktueller Messdaten des Drehstromstellers erfolgt.

2. Verfahren nach Anspruch 1, **dadurch gekennzeichnet, dass** wenigstens jede Netzperiode die Effektivwerte der in den beiden gesteuerten Phasen fließende Ströme erfasst werden.

3. Verfahren nach Anspruch 1 oder 2, **dadurch gekennzeichnet, dass** die Effektivwerte aus digitalisierten Werten bestimmt werden.

4. Verfahren nach einem der Ansprüche 1 bis 3, **dadurch gekennzeichnet, dass** eine Regelverstärkung im Bereich von 0,03 bis 0,05 verwendet wird.

5. Zweiphasiger Drehstromsteller zur Phasenanschnittsteuerung von zwei gesteuerten Phasen in einem Drehstromnetz,

   - mit Erfassungsmittel zum Erfassen der Effektivwerte der in den beiden gesteuerten Phasen fließenden Ströme, und
   - mit einer mit den Erfassungsmitteln in Verbindung stehender Steuereinheit, die Summierungsmittel zum Aufsummieren der Differenz der in den beiden gesteuerten Phasen fließenden Ströme aufweist, und die zur Bestimmung und Generierung einer Zündverzögerung aus der aufsummierten Differenz der in den beiden gesteuerten Phasen fließenden Ströme ausgebildet ist, derart, dass durch Erhöhen des Zündwinkels für die erste gesteuerte Phase und Erniedrigen des Zündwinkels für die zweite gesteuerte Phase um die bestimmte Zündverzögerung die Effektivwerte in den beiden gesteuerten Phasen angeglichen werden, wobei die Angleichung aufgrund aktueller Messdaten des Drehstromstellers erfolgt.

**Claims**

1. Method for operation of a two-phase three-phase controller in a three-phase power supply system, with phase gating control being carried out in two control phases, having the following steps:

    - detection of the root mean square values of the currents flowing in the two control phases,
    - addition of the difference between the currents flowing in the two control phases,
    - determination of a trigger delay from the added-up difference between the currents flowing in the two control phases, and
    - increasing of the trigger angle of the first control phase and reduction of the trigger angle for the second control phase by the determined trigger delay in such a manner that the root mean square values in the two control phases are matched, wherein the matching is carried out on the basis of instantaneous meaurement data of the three-phase controller.

2. Method according to Claim 1, **characterized in that** the root mean square values of the currents flowing in the two control phases are detected at least in each power supply system cycle.

3. Method according to Claim 1 or 2, **characterized in that** the root mean square values are determined from digitized values.

4. Method according to one of Claims 1 to 3, **characterized in that** a control gain in the range from 0.03 to 0.05 is used.

5. Two-phase three-phase controller for phase gating control of two control phases in a three-phase power supply system,

    - having detection means for detection of the root mean square values of the currents flowing in the two control phases, and
    - having a control unit which is connected to the detection means and has addition means for addition of the difference between the currents flowing in the two control phases, and which is designed to determine and generate a trigger delay from the added-up difference between the currents flowing in the two control phases, in such a manner that the root mean square values in the two control phases are matched by increasing the trigger angle of the first control phase and by reducing the trigger angle for the second control phase, wherein the matching is carried out on the basis of instantaneous meaurement data of the three-phase controller.

**Revendications**

1. Procédé pour faire fonctionner un régulateur de courant triphasé à deux phases dans un réseau à trois phases, dans lequel un réglage de phases s'effectue dans deux phases commandées comprenant les stades :

    - détection des valeurs efficaces des courants passant dans les deux phases commandées,
    - accumulation de la différence des courants passant dans les deux phases commandées,
    - détermination d'un retard à l'allumage à partir de la différence accumulée des courants passant dans les deux phases commandées et
    - augmentation de l'angle d'allumage pour la première phase commandée et diminution de l'angle d'allumage pour la deuxième phase commandée du retard d'allumage déterminé de façon à égaliser les valeurs efficaces dans les deux phases commandées, l'égalisation s'effectuant sur la base des données de mesure présentes du régulateur de courant triphasé.

2. Procédé suivant la revendication 1, **caractérisé en ce que** dans au moins chaque période du réseau on détecte les valeurs efficaces des courants passant dans les deux phases commandées.

3. Procédé suivant la revendication 1 ou 2, **caractérisé en ce qu'**on détermine les valeurs efficaces à partir de valeurs numérisées.

4. Procédé suivant l'une des revendications 1 à 3, **caractérisé en ce qu'**on utilise une amplification de régulation de l'ordre de 0,03 à 0,05.

5. Régulateur triphasé à deux phases pour la commande de phases de deux phases commandées dans un réseau triphasé,

- comprenant un moyen de détection des valeurs efficaces des courants passant dans les deux phases commandées et
- comprenant une unité de commande qui est en liaison avec les moyens de détection et qui a des moyens d' accumulation pour accumuler la différence des courants passant dans les deux phases commandées et qui est constituée pour la détermination et la production d'un retard à l'allumage à partir de la différence accumulée des courants passant dans les deux phases commandées de manière à égaliser, en augmentant l'angle d' allumage pour la première phase commandée et en abaissant l'angle d' allumage pour la deuxième phase commandée du retard à l'allumage déterminé, les valeurs efficaces dans les deux phases commandées, l' égalisation s' effectuant sur la base des données de mesure présentes du régulateur triphasé.

## FIG 1
Stand der Technik

## FIG 2
Stand der Technik

## FIG 3

## FIG 4

FIG 5

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 0148903 A
- US 5682091 A, WILLIAMSON
- GB 1227963 A
- US 4101819 A, MAEDA